Europäisches Patentamt

European Patent Office

Office européen des brevets

(19)

(11) Publication number: **0 042 264**
**B1**

(12) **EUROPEAN PATENT SPECIFICATION**

(45) Date of publication of patent specification: **02.10.85**

(21) Application number: **81302616.8**

(22) Date of filing: **12.06.81**

(51) Int. Cl.⁴: **H 03 C 1/62,** H 04 B 1/04,
H 03 F 3/24

(54) **Circuit for supplying an amplitude modulated current to an R.F. stage of a radio transmitter.**

(30) Priority: **18.06.80 GB 8019991**
**27.02.81 GB 8106251**

(43) Date of publication of application:
**23.12.81 Bulletin 81/51**

(45) Publication of the grant of the patent:
**02.10.85 Bulletin 85/40**

(84) Designated Contracting States:
**CH DE FR IT LI NL SE**

(56) References cited:
**EP-A-0 042 272**
**DE-A-1 766 586**
**DE-A-2 741 038**
**DE-A-2 821 683**
**DE-A-2 834 029**
**DE-A-2 843 425**
**DE-B-1 218 557**
**DE-B-2 720 930**
**US-A-3 588 744**

**TECHNISCHE MITTEILUNG AEG-
TELEFUNKEN, Vol. 69, No. 3, 1979, B.
WYSOCKI "Die neue Hochleitungssender-
Familie PANTEL von AEG-Telefunken"**

(73) Proprietor: **THE MARCONI COMPANY LIMITED
Marconi House New Street
Chelmsford Essex CM1 1PL (GB)**

(72) Inventor: **Molyneux-Berry, Robert Bewes
12, Hopping Jacks Lane
Danbury Essex (GB)**
Inventor: **Brett, John Edward
1, Roland Close
Broomfield Chelmsford Essex, CM1 5ED (GB)**

(74) Representative: **Tolfree, Roger
The Marconi Company Limited Marconi House
New Street
Chelmsford, CM1 1PL (GB)**

Courier Press, Leamington Spa, England.

EP 0 042 264 B1

## Description

This invention relates to a circuit for supplying an amplitude modulated current to an R.F. stage of a radio transmitter.

More particularly the invention relates to the type of circuit which comprises a voltage source arranged to supply current to the R.F. stage of the transmitter, a pulse width encoder for converting an amplitude modulated signal into pulse width modulated form, amplifying means for amplifying the pulse width modulated signal, an energy store for converting the amplified pulse width modulated signal back to amplitude modulated form and means for applying the amplified amplitude modulated signal to the R.F. stage so as to modulate the current supplied thereto. Hitherto all such circuits have used a common voltage source to supply current to the R.F. stage and to supply power for the amplifier. Several such circuits are described in German Patent Specification DE—B—1218557, the circuit shown in Fig. 5 thereof employing a tapped voltage source of which at least the lower part feeds both the R.F. stage of the transmitter and the audio amplifying means.

Circuits of the aforementioned type are sometimes required to operate at very high power levels and this requirement can cause problems.

One such problem is so-called "carrier compression" which is a reduction in the amplitude of the carrier as a result in fluctuations in the audio voltage of the power source occasioned by varying demands for current from it. Such variations in demand occur because of the varying amplitude of the modulating signal.

Another problem arises from the risk of electrical breakdown of switching tubes and/or audio frequency transformers or other components required to handle the entire current fed to the R.F. stage. Such breakdown may not only damage the component concerned, but may overload and cause serious damage to the power source. The power source, therefore, has to be provided with a protection system (e.g. a circuit breaker) which can handle a high current and yet is able to respond rapidly when the current exceeds a maximum safe value. The provision of such a protection system itself constitutes a problem since the current values concerned may be very high indeed.

In accordance with the present invention the amplifying means of a circuit of the aforementioned type is connected to receive its power for amplification from a second voltage source, which is separate from the voltage source supplying current to the R.F. stage, and a D.C. blocking capacitor is used to apply the amplified signal to the R.F. stage.

For the purpose of this specification, separate voltage sources are defined as being voltage sources for which variations in current drawn from either one do not substantially affect the other. The two voltage sources may ultimately draw their power from a common prime source, e.g. an electric mains supply. Such sources use separate apparatus to convert the mains supply to a required rectified voltage, and thus are separate in the particular sense of there being no significant coupling between them, i.e. variations of current drawn from either supply do not sensibly affect the other. Where both sources include a rectifier, no power can be fed back into either source, and no current can circulate between the two, either normally, or (especially) under fault conditions. In particular, sustained fault current cannot flow from the higher voltage source to the lower.

Because the carrier power is supplied by its own voltage source, independent of the voltage source for the amplifier, fluctuations in amplifier current demand do not affect the carrier power. Carrier compression can thus be reduced or avoided.

Because the invention uses two voltage sources, two respective protection systems may be required. The first protection system (which protects the first voltage supply and/or its load circuit) can be a relatively simple device since it is not normally required to respond very rapidly. This therefore presents no serious problems of expense or reliability. The second protection system (which protects the second voltage supply and parts of the circuit directly connected to it) does need to respond quickly. However, in accordance with the invention, it handles only part of the power (the side bands) delivered to the load and therefore can be more reliable than existing fast acting protection devices included in systems where one voltage source (which may incidentally be constituted by two components connected in series) is used to supply all the power to the load.

One way in which the invention may be performed will now be described by way of example with reference to the accompanying schematic drawings in which:—

*Figure 1* illustrates a circuit constructed in accordance with the invention and

*Figure 2* shows various waveforms which appear at different parts of the circuit shown in Figure 1.

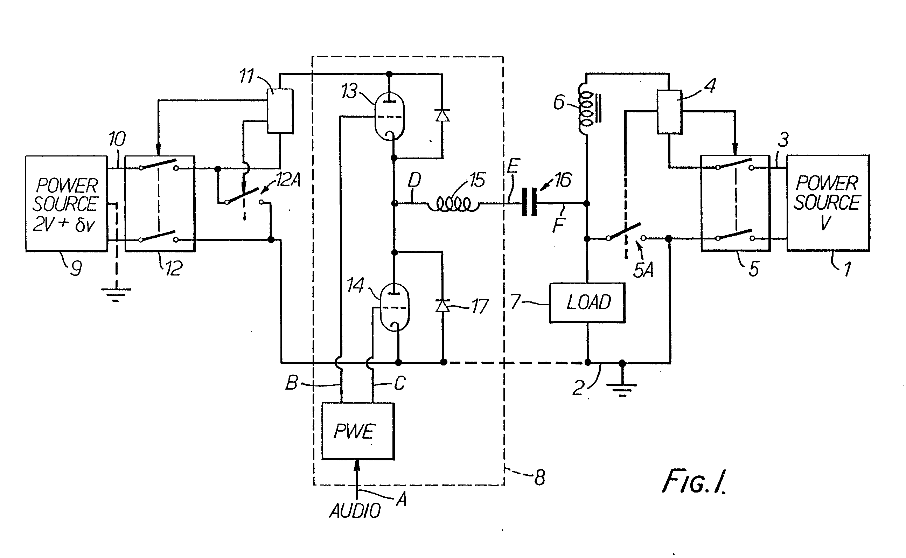

Referring firstly to Figure 1, a first voltage or power source 1 has an output line connected to a grounded conductor 2 and another output line 3 to which it applies a rectified voltage V. The current through the line 3 is monitored by a current sensing device 4 which provides a control signal when the current exceeds a safe value. Additional conventional sensing devices may be fitted at other parts of the circuit to provide a like control signal in the event of other types of fault. The control signal is operative to open contacts of a circuit breaker 5 and, in the particular systems illustrated, also closes additional contacts 5A. The components 4, 5 and 5A are collectively termed a "protection device". It does not have to be particularly fast acting because an audio blocking inductor 6 prevents a rapid rise in current.

The power source 1 is reponsible for the production of a steady current which passes through the audio-blocking inductor 6 and a load 7 and provides power at an R.F. carrier frequency.

The load 7 is the R.F. valve of a radio transmitter the anode of which, for correct operation under unmodulated carrier conditions, needs to be maintained at a steady voltage of approximately V volts, this requirement being met by the power source 1.

The transmitter is amplitude modulated by superimposing an audio voltage on the anode of the R.F. valve, i.e. at point F on Figure 1. The most efficient and effective degree of modulation is obtained when the maximum (i.e. loudest) audio signal to be handled by the transmitter has a peak-to-peak amplitude of 2V at the R.F. valve anode; i.e. the potential of point F varies, in accordance with the audio signal, between zero volts (ground potential) and peaks of 2V. This is termed 100% amplitude modulation. It is normally important in broadcasting transmitters to avoid or minimise audio distortion.

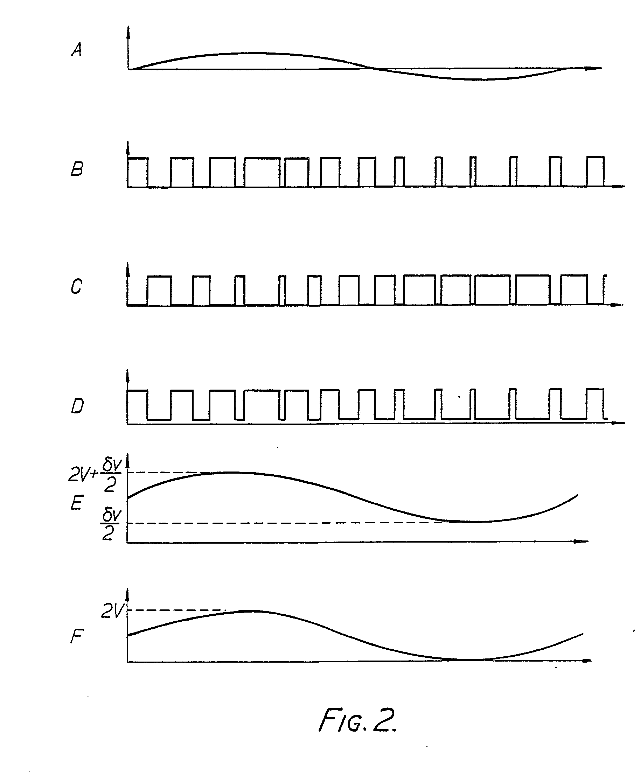

The anode voltage is modulated by an audio signal which is introduced at point A shown on Figure 1, this signal being represented diagrammatically at A on Figure 2. The signal A is amplified by a pulse width modulation amplifier 8 which is supplied with power from a second power source 9 which is notably not connected to the first power source by a direct current discharge path. This power source 9 has, in the illustrated circuit, one output line connected to the grounded conductor 2 and maintains a rectified voltage of 2V+δV on its other output line 10. Positioned in line 10 is a current sensor 11 which, when it senses a current in excess of that which can safely be delivered by the source 9 or which can safely be passed by switches 13 and 14, to be described later, produces a control signal which operates a fast acting circuit breaker 12 and an even faster acting switch 12A. A like control signal may be produced by one or more additional conventional fault sensing devices elsewhere in the circuit. The components 11, 12 and 12A in combination constitute a second protection device. However, unlike the protection device 4, 5 and 5A which can be relatively slow to respond to excessive currents, because the inductor 6 limits the rate of rise of current, the protection device 11, 12 and 12A needs to the able to respond very quickly. It is notable however that this second protection device does not handle all the power delivered to the load since most of this is supplied from power source 1. Because it does not handle all the power, the device 11, 12 and 12A can be designed to operate reliably with much less difficulty than if it had needed to handle the whole power consumed by the load.

The pulse width modulation amplifier 8 will now be described. The input signal is shown in Figure 2 and is composed of parts where its voltage exceeds zero and parts where its voltage is below zero. This waveform A is converted by the pulse width encoder P.W.E. whose construction may be of a known type, into a series of pulses B (Figures 1 and 2) the width of each pulse depending on the instantaneous voltage level of A. Thus the pulse length is a minimum at times coincident with troughs in the waveform A; and the pulse width is at a maximum at times when the waveform A is at a positive peak. When the waveform A is at zero the pulse length at B is approximately half the duration of the spaces between pulses. In this particular pulse width encoder the maximum pulse width is a little less than the pulse repetition period to avoid distortion which would otherwise occur if the pulses are not perfectly shaped. Similarly, the minimum pulse width is greater than zero, also for the purpose of avoiding distortion.

In the illustrated system the pulse width encoder P.W.E. also produces an output C which is the inverse of output B. The signals B and C are used to switch valves 13 and 14 in such a way that, when waveform B is at a high level, the valve 13 is switched on, and, when C is at a high level, the valve 14 is switched on. When the valve 13 is switched on it has very low resistance and so the point D is a little less than 2V+δV volts as supplied by the power source 9. At other times, when the valve 14 is switched on, the point D is a little above zero volts because it is effectively switched to the earthed line 2. The voltage at point D therefore fluctuates between just below 2V+δV volts and just above zero volts as shown at D on Figure 2. This follows the waveform of B. The *average* voltage at D therefore follows the waveform A but is greatly amplified.

In an alternative embodiment (not illustrated) only the signal C is generated by the pulse width encoder, and applied to value 14 as in Figure 1. The grid control circuit of valve 13 is connected to the anode of valve 14 in such a way that the valves 13 and 14 conduct in anti-phase. There are several known methods of performing this.

An energy store in the form of an inductor 15 is used to provide a voltage E whose value represents the short term average voltage at D. Further energy storage components of conventional type, may be added to improve the degree to which the pulses are filtered out. With no audio signal at A the D.C. voltage at E is in excess of the voltage V by approximately δV/2 but no D.C. current flows through inductor 15, such current being prevented by capacitor 16. Where an audio signal of maximum modulation is applied at A the voltage E varies between about δV/2 and 2V+δV/2 in response to variations in the average voltage at D. Thus the variation in voltage E can equal 2V even though 100% pulse width modulation (with its associated distortion) has not been employed. The 2V voltage variation at E is applied to the load 7 through the capacitor 16, thus modulating the load voltage between O and 2V as shown at F. This technique is the subject of the claims of our co-pending European application 0042272.

In the circuit shown in Figure 1 the first power source 1 is required to supply a steady current to the load 7. However, this is not essential and the invention is applicable to systems having a controlled carrier level.

In another modification the amplifier 8 is not connected to the earthed conductor 2, the part of the line 2 shown in broken lines being omitted. Instead, the line 10 may be earthed or an earth connection may be made to a centre tap on the power source 9, also as shown in broken lines. An advantage of such a centre tap is that the maximum voltage between earth and either output of the power source is just a little over V volts instead of over 2V volts.

**Claims**

1. A circuit for supplying an amplitude modulated current to an R.F. stage (7) of a radio transmitter, the circuit comprising a first voltage source (1) arranged to supply current to the R.F. stage, a pulse width encoder (PWE) for converting an amplitude modulated signal (A) into pulse width modulated form (B,C), amplifying means (13, 14) for amplifying the pulse width modulated signal, an energy store (15) for converting the amplified pulse width modulated signal (D) back to amplitude modulated form (E) and means for applying the amplified amplitude modulated signal (E) to the R.F. stage so as to modulate the current supplied thereto; characterised in that the amplifying means (13, 14) is connected to receive its power for amplification from a second voltage source (9) which is separate from the first voltage source (1) and in that the means for applying the amplified signal (E) to the R.F. stage (7) comprise a D.C. blocking capacitor (16).

2. A circuit according to claim 1 characterised by: a first protecting device (4, 5, 5A) for protecting the first voltage source (1) against overload and a second protecting device (11, 12, 12A), for protecting the second voltage source (9) against overload.

3. A circuit according to claim 2 characterised in that the second protection device (11, 12, 12A) is relatively fast-acting compared with the first protection device (4, 5, 5A).

4. A circuit according to claim 1, 2 or 3 characterised by an inductor (6) connected between the load (7) and the first voltage source (1) to isolate the latter from audio frequency signals produced by the amplifier (8).

5. A circuit according to any preceding claim characterised in that the amplifying means comprises two switching devices (13, 14) connected in series across the second voltage source (9), the switching devices being arranged to be switched by pulses of the pulse width modulated signal and being arranged so that, when one is open circuited, the other is closed circuited, and in that the energy store is connected to a point between the switching devices (13, 14).

6. A circuit according to claim 5 wherein the voltage of the second voltage source (9) exceeds twice the voltage of the first voltage source (1).

7. A circuit according to any preceding claim characterised in that said energy store includes an inductor (15).

**Patentansprüche**

1. Eine Schaltung zum Zuführen eines amplitudenmodulierten Stromes zu einer HF-Stufe (7) eines Radiosenders, wobei die Schaltung umfaßt eine erste Spannungsquelle (1), die zum Zuführen von Strom zu der HF-Stufe ausgelegt ist, einen Impulsbreiten-Kondierer (PWE) zum Wandeln eines amplitudenmodulierten Signales (A) in impulsbreitenmodulierte Form (B, C), Verstärkermittel (13, 14) zum Verstärken des impulsbreitenmodulierten Signals, einen Energiespeicher (15) zum Zurückwandeln des verstärkten impulsbreitenmodulierten Signales (D) in amplitudenmodulierte Form (E) und Mittel zum Anlegen des verstärkten amplitudenmodulierten Signales (E) an die HF-Stufe, um so den dort zugeführten Strom zu modulieren, dadurch gekennzeichnet, daß die Verstärkermittel (13, 14) so angeschlossen sind, daß sie ihre Energie zum Verstärken von einer zweiten Spannungsquelle (9) erhalten, die getrennt von der ersten Spannungsquelle (1) vorhanden ist, und daß die Mittel zum Anlegen des verstärkten Signales (E) an die HF-Stufe (7) einen gleichstromsperrenden Kondensator (16) umfassen.

2. Eine Schaltung nach Anspruch 1, gekennzeichnet durch: eine erste Schutzeinrichtung (4, 5, 5A) zum Schützen der ersten Spannungsquelle (1) vor Überlastung und eine zweite Schutzeinrichtung (11, 12, 12A) zum Schützen de zweiten Spannungsquelle (9) vor Überlastung.

3. Eine Schaltung nach Anspruch 2, dadurch gekennzeichnet, daß die zweite Schutzeinrichtung (11, 12, 12A), im Vergleich zur ersten Schutzeinrichtung (4, 5, 5A) relativ schnellwirkend ist.

4. Eine Schaltung nach Anspruch 1, 2 oder 3, gekennzeichnet durch eine zwischen der Last (7) und der ersten Spannungsquelle (1) zum Isolieren der letzteren gegen durch den Verstärker (8) erzeugte Audiofrequenz-Signale angeschlossene Induktivität (6).

5. Eine Schaltung nach einem der vorangehenden Ansprüche, dadurch gekennzeichnet, daß die Verstärkermittel zwei in Reihe über der zweiten Spannungsquelle (9) angeschlossene Schalteinrichtungen (13, 14) umfassen, wobei die Schalteinrichtungen so angeordnet sind, daß sie durch Impulse des impulsbreitenmodulierten Signales geschaltet werden und so ausgelegt, daß dann, wenn die eine geöffnet, die andere geschlossen ist, und daß der Energiespeicher an eine Stelle zwischen den Schalteinrichtungen (13, 14) angeschlossen ist.

6. Eine Schaltung nach Anspruch 5, bei der die Spannung der zweiten Spannungsquelle (9) zweimal die Spannung der ersten Spannungsquelle übertrifft.

7. Eine Schaltung nach einem der vorangehenden Ansprüche, dadurch gekennzeichnet, daß der Energiespeicher eine Induktivität (15) enthält.

**Revendications**

1. Circuit servant à délivrer un courant modulé en amplitude à l'étage H.F. (7) d'un émetteur radio-électrique, le circuit comprenant une première source de tension (1) disposée de façon à dèlivrer du courant à l'étage H.F., un codeur en largeur d'impulsion (P.W.E.) servant à transformer un signal modulé en amplitude (A) en un signal (B, C) du type modulé en largeur d'impulsion, un moyen d'amplification (13, 14) servant à amplifier le signal modulé en largeur d'impulsion, un moyen (15) d'emmagasinage d'énergie servant à retransformer le signal modulé en largeur d'impulsion amplifie (D) en un signal (E) du type modulé en amplitude, et un moyen servant à appliquer le signal modulé en amplitude amplifié (E) à l'étage H.F. afin de moduler le courant qui lui est délivré; caractérisé en ce que le moyen d'amplification (13, 14) est connecté de façon à recevoir son énergie électrique d'amplification de la part d'une deuxième source de tension (9) qui est distincte de la première source de tension (1) et en ce que le moyen qui applique le signal amplifié (E) à l'étage H.F. (7) comprend un condensateur (16) d'arrêt de courant continu.

2. Circuit selon la revendication 1, caractérisé par un premier dispositif de protection (4, 5, 5A) servant à protéger la première source de tension (1) contre les surcharges et un deuxième dispositif de protection (11, 12, 12A) servant à protéger la deuxième source de tension (9) contre les surcharges.

3. Circuit selon la revendication 2, caractérisé en ce que le deuxiéme dispositif de protection (11, 12, 12A) est du type à action relativement rapide par comparaison avec le premier dispositif de protection (4, 5, 5A).

4. Circuit selon la revendication 1, 2 ou 3, caractérisé par une inductance (6) connectée entre la charge (7) et la première source de tension (1) afin d'isoler cette dernière vis-à-vis des signaux d'audiofrequence produits par l'amplificateur (8).

5. Circuit selon l'une quelconque des revendications précédentes, caractérisé en ce que le moyen d'amplification comprend deux dispositifs de commutation (13, 14) connectes en série sur la deuxième source de tension (9), les dispositifs de commutation étant conçus de façon à être commutés par des impulsions du signal modulé en largeur d'impulsion et étant conçus de façon que, lorsque l'un est en circuit ouvert, l'autre est en circuit fermé; et en ce que le moyen d'emmagasinage d'énergie est connecté à un point situé entre les moyens de commutation (13, 14).

6. Circuit selon la revendication 5, où la tension de la deuxième source de tension (9) dépasse deux fois la tension de la première source de tension (1).

7. Circuit selon l'une quelconque des revendications précédentes, caractérisé en ce que ledit moyen d'emmagasinage d'énergie comporte une inductance (15).

FIG. 1.

0 042 264

FIG. 2.

2